# EUROPEAN PATENT APPLICATION

(11) **EP 4 484 194 A1**
(43) Date of publication of application: **01.01.2025**
(21) Application number: 22951085.4
(22) Date of filing: 13.07.2022
(51) Int. Cl.: B60K 11/02

(54) **COOLING MODULE**

(71) Applicant: AISIN CORPORATION, Kariya-shi, Aichi 448-8650 (JP)
(72) Inventor: ISHII Masato, Kariya-shi, Aichi 448-8650 (JP); YANO Hideto, Kariya-shi, Aichi 448-8650 (JP)
(74) Representative: Kramer Barske Schmidtchen Patentanwälte PartG mbB
(86) International application number: PCT/JP2022/027526
(87) International publication number: WO 2024/013871

(57) **Abstract**

A cooling module does not include a reserve tank inside, but includes a manifold made of resin and including a plurality of housings joined to each other, and the manifold includes a plurality of channels formed across at least two of the plurality of housings.

## Description

### TECHNICAL FIELD

The present invention relates to a cooling module.

### BACKGROUND ART

In recent years, an automobile (hybrid electric vehicle (HEV), plug-in hybrid electric vehicle (PHEV), battery electric vehicle (BEV), fuel-cell electric vehicle (FCEV), and the like) including a motor as a traveling drive source has been widely used. These automobiles (hereinafter, collectively referred to as an "electric vehicle") include a battery for driving motors. In the electric vehicle, there are many devices that require cooling, such as the motors (including an internal combustion engine such as an engine), the battery, an air conditioner, and an ECU. Therefore, a cooling circuit that circulates cooling water is included to cool these devices. However, these devices may have different appropriate operating temperatures. In such a case, because temperature of the cooling water to be circulated is changed for each device having different operating temperatures, it is necessary to include an independent cooling circuit for each temperature of the cooling water, requiring complicated routing of cooling circuit pipes and circuit configuration.

In order to solve such a problem, for example, there is a technique described in Patent Literature 1. Patent Literature 1 discloses a cooling module (integrated coolant bottle assembly in Patent Literature 1) in which components such as a pump, a chiller, a heater, a filter, valve, and a fan are mounted on a reserve tank (reservoir in Patent Literature 1), and a channel (integrated channel in Patent Literature 1) between the components is formed integrally with the reserve tank.

### CITATIONS LIST

### PATENT LITERATURE

Patent Literature 1: JP 2019-520261 T

### SUMMARY OF INVENTION

### TECHNICAL PROBLEMS

In the cooling module disclosed in Patent Literature 1, the components are mounted on the reserve tank. Therefore, the components are required to be mounted on the reserve tank according to a shape of the reserve tank, and there is a mounting space only on a surface of the reserve tank. Therefore, the mounting space is determined by capacity of the reserve tank, and thus when the pump or the valve is mounted in on the limited mounting space, positions and directions in which the channel, inflow port, and outflow port of cooling water are disposed are restricted, by which flexibility in design of the cooling circuit may be reduced. As a result, positions and directions of the pipes mounted on the inflow port and the outflow port are affected, and routing of the pipes may still be complicated.

The present invention has been made in view of the above problems, and provides a cooling module on which auxiliary units such as a pump and a valve are integrally mounted, and in which channels are organized to align positions and orientations of inflow ports and outflow ports.

### SOLUTIONS TO PROBLEMS

One embodiment of a cooling module according to the present invention does not include a reserve tank inside, and includes a manifold made of resin and including a plurality of housings joined to each other, and the manifold includes a plurality of channels formed across at least two of the plurality of housings.

According to the present embodiment, the manifold incudes the plurality of channels formed by extending across at least two housings, and thus the number of pipes can be reduced. Furthermore, because the manifold is configured by joining the plurality of housings, even if shapes and configuration of the channels in the manifold are complicated due to consideration of positions and directions of ports to which the pipes are connected, a shape of each housing can be simplified. Thus, because the pipes connected to the ports can be integrated to avoid redundant routing, lengths of the pipes connected to the ports can be shortened and simplified. Furthermore, because the cooling module does not include a reserve tank, it is possible to configure the cooling module to be compact and increase flexibility in disposition of the cooling module. Thus, it is possible to provide a cooling module in which the channels in the manifold are organized to align positions and orientations of inflow ports and outflow ports.

Another embodiment of the cooling module according to the present invention further includes a first auxiliary unit and a second auxiliary unit that control flow of fluid flowing through the channels, in which a plurality of the housings include a first housing and a second housing joined to the first housing, and the first auxiliary unit is mounted on the first housing, and the second auxiliary unit is mounted on the second housing.

According to the present embodiment, by mounting the first auxiliary unit and the second auxiliary unit on different housings, the strength of the housing necessary for holding the auxiliary units can be optimized according to a type of the auxiliary units.

In another embodiment of the cooling module according to the present invention, the first housing is disposed joined to an upper side of the second housing in a vertical direction, the first housing includes a plurality of inflow ports communicating with a plurality of the respective channels, and a plurality of the inflow ports are arranged side by side so that axes thereof are along the vertical direction and on the same plane.

According to the present embodiment, by arranging the inflow ports side by side so that the axes thereof are along the vertical direction and on the same plane, the pipes connected to the inflow ports can be integrated to avoid redundant routing, and thus lengths of the pipes connected to the inflow ports can be shortened and simplified.

In another embodiment of the cooling module according to the present invention, the first auxiliary unit is a rotary valve, and a valve body of the rotary valve is positioned in the second housing.

According to the present embodiment, by positioning the valve body of the rotary valve in the second housing, a flow of the fluid flowing through the plurality of channels can be controlled by switching between the channels formed in the second housing.

In another embodiment of the cooling module according to the present invention, the second housing includes a mounting portion on which the second auxiliary unit is mounted, and the mounting portion is thicker than other portions.

According to the present embodiment, it is possible to ensure strength of even a manifold made of resin to be mounted with and hold a heavy auxiliary unit.

In another embodiment of the cooling module according to the present invention, the second auxiliary unit is a water pump that pumps the fluid, and the water pump and the second housing constitute a vortex chamber through which the fluid flows.

According to the present embodiment, the water pump does not require a shroud for regulating inflow and outflow directions of the fluid, and therefore, downsizing, weight reduction, and cost reduction of the cooling module are possible.

In another embodiment of the cooling module according to the present invention, a plurality of the channels include a first channel that constitutes a part of a first circulation path that circulates through a radiator, a second channel that constitutes a part of a second circulation path that circulates through a heater core, a third channel that constitutes a part of a third circulation path that circulates through a battery, and a communication channel that allows the first channel, the second channel, and the third channel to communicate with one another.

According to the present embodiment, by providing, in the cooling module, the first channel that constitutes a part of the first circulation path, the second channel that constitutes a part of the second circulation path, the third channel that constitutes a part of the third circulation path, and the communication channel that allows the first channel, the second channel, and the third channel to communicate with one another, the circulation paths through which the fluid circulates can be integrated, and thus the number of pipes connected to the ports can be reduced, and lengths of the pipes can be shortened and simplified.

In another embodiment of the cooling module according to the present invention, the communication channel is formed along a joining surface of each of a plurality of the housings.

According to the present embodiment, by forming the communication channel on the joining surfaces, the first channel, the second channel, and the third channel can communicate with each other even if the channels partially lie in both the first housing and the second housing.

### BRIEF DESCRIPTION OF DRAWINGS

FIG. 1 is a circuit configuration diagram of a cooling system including a cooling module according to the present embodiment.
FIG. 2 is a perspective view of the cooling module.
FIG. 3 is an exploded perspective view of the cooling module.
FIG. 4 is a perspective view of a first housing as viewed from a joining surface side.
FIG. 5 is an exploded perspective view of the cooling module.
FIG. 6 is a cross-sectional view taken along the line VI-VI in FIG. 3.
FIG. 7 is a perspective view of a lower housing as viewed from a joining surface side.
FIG. 8 is a cross-sectional view taken along the line VIII-VIII in FIG. 2.
FIG. 9 is a diagram showing a first aspect of operation of the cooling system.
FIG. 10 is a diagram showing a second aspect of the operation of the cooling system.
FIG. 11 is a diagram showing a third aspect of the operation of the cooling system.
FIG. 12 is a diagram showing a fourth aspect of the operation of the cooling system.

### DESCRIPTION OF EMBODIMENTS

Hereinafter, one embodiment of a cooling module according to the present invention will be described in detail with reference to the drawings. Note that embodiments described below are examples for describing the present invention, and the present invention is not limited only to these embodiments. Therefore, the present invention can be implemented in various forms without departing from the gist thereof.

### [Configuration of cooling system]

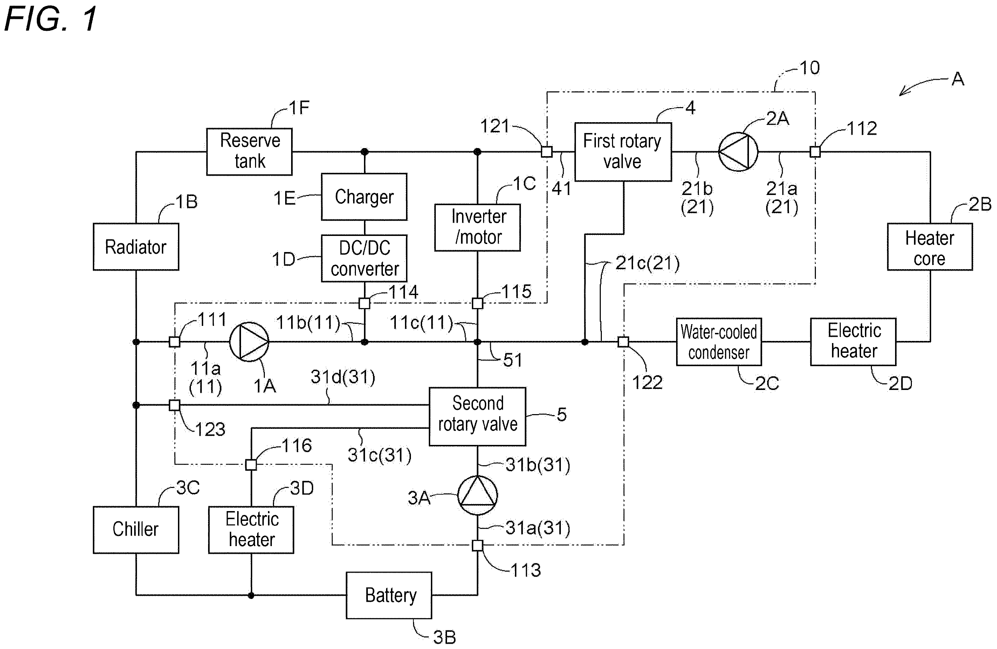

As shown in FIG. 1, a cooling system A including a cooling module 10 according to the present embodiment includes a first water pump 1A (an example of a second auxiliary unit), a radiator 1B, an inverter/motor 1C, a DC-DC converter 1D, a charger 1E, a reserve tank 1F, a second water pump 2A (an example of the second auxiliary unit), a heater core 2B, an electric heater 2D, a water-cooled condenser 2C, a third water pump 3A (an example of the second auxiliary unit), a battery 3B, a chiller 3C, an electric heater 3D, a first rotary valve 4 (an example of a first auxiliary unit), a second rotary valve 5 (an example of the first auxiliary unit), and a plurality of channels for circulating cooling water (an example of fluid, coolant) therethrough. Among them, the first water pump 1A, the second water pump 2A, the third water pump 3A, the first rotary valve 4, and the second rotary valve 5 are mounted on the cooling module 10. Meanwhile, the radiator 1B, the inverter/motor 1C, the DC-DC converter 1D, the charger 1E, the reserve tank 1F, the heater core 2B, the electric heater 2D, the water-cooled condenser 2C, the battery 3B, the chiller 3C, and the electric heater 3D are disposed spaced apart from the cooling module 10, and are configured such that the cooling water flows therethrough and through the cooling module 10, via a plurality of channels.

The cooling system A is used in an automobile including a motor as a traveling drive source (hereinafter, collectively referred to as an "electric vehicle"), such as, for example, a hybrid electric vehicle (HEV), plug-in hybrid electric vehicle (PHEV), battery electric vehicle (BEV), fuel-cell electric vehicle (FCEV), and circulates the cooling water to cool the inverter/motor 1C, the battery 3B, and the like.

The radiator 1B cools high-temperature cooling water. The inverter/motor 1C is a traveling drive source that operates with electric power supplied from the battery 3B. The DC-DC converter 1D and the charger 1E charge the battery 3B. The heater core 2B heats air with the high-temperature cooling water to heat a vehicle interior. The electric heaters 2D and 3D heat the cooling water when temperature of the cooling water is low. The water-cooled condenser 2C and the chiller 3C are cooled when the temperature of the cooling water is high. The battery 3B supplies power to the inverter/motor 1C.

The first water pump 1A pumps the cooling water to be supplied to the inverter/motor 1C, the DC-DC converter 1D, and the charger 1E. The second water pump 2A pumps the cooling water to be supplied to the heater core 2B, the electric heater 2D, and the water-cooled condenser 2C. The third water pump 3A pumps the cooling water to be supplied to the battery 3B, the chiller 3C, and the electric heater 3D. The first water pump 1A, the second water pump 2A, and the third water pump 3A control flow of the cooling water flowing through the plurality of channels by pumping the cooling water.

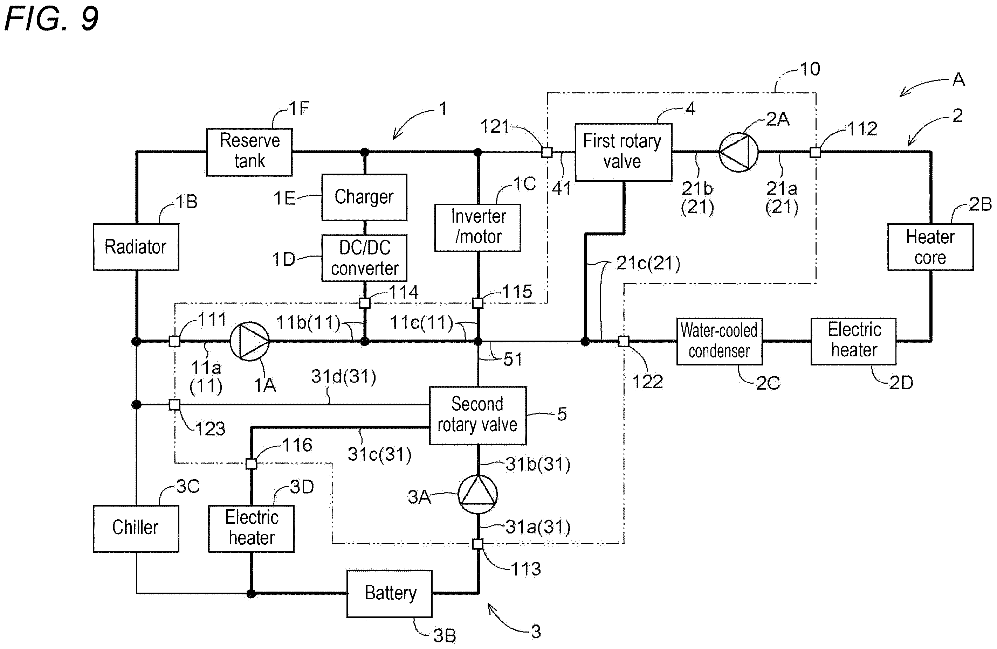

Hereinafter, a circulating channel configured to pass from the radiator 1B through the first water pump 1A, the inverter/motor 1C, the DC-DC converter 1D, the charger 1E, and the reserve tank 1F and return to the radiator 1B is referred to as a first circulation path 1 (refer to FIG. 9), and, of the first circulation path 1, a channel formed in the cooling module 10 is referred to as a first channel 11. Similarly, a circulating channel configured to pass from the heater core 2B through the second water pump 2A, the water-cooled condenser 2C, and the electric heater 2D and return to the heater core 2B is referred to as a second circulation path 2 (refer to FIG. 9), and, of the second circulation path 2, a channel formed in the cooling module 10 is referred to as a second channel 21. Similarly, a circulating channel configured to pass from the battery 3B through the third water pump 3A, the chiller 3C, and the electric heater 3D and return to the battery 3B is referred to as a third circulation path 3 (refer to FIG. 9), and, of the third circulation path 3, a channel formed in the cooling module 10 is referred to as a third channel 31. Furthermore, a communication channel 51 (an example of a channel) that allows the first channel 11, the second channel 21 and the third channel 31 to communicate with each other is formed in the cooling module 10. A channel configuration in the cooling module 10 will be described later.

### [Configuration of cooling module]

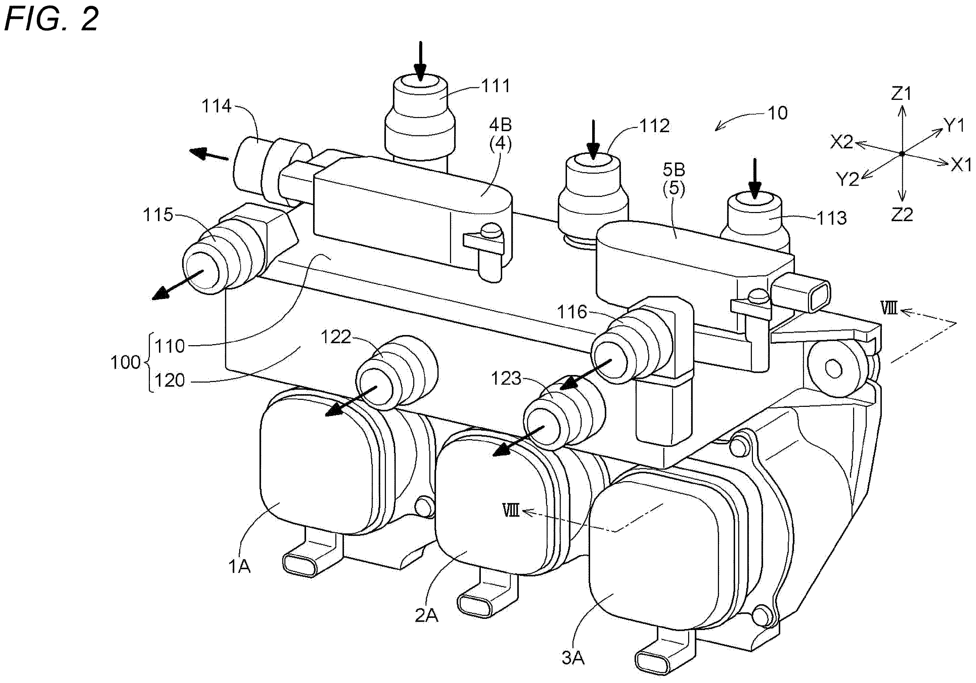

As shown in FIGS. 2 to 8, of the cooling system A, the cooling module 10 includes the first water pump 1A, the second water pump 2A, the third water pump 3A, the first rotary valve 4, the second rotary valve 5, and a manifold 100 in which channels that allow the cooling water to flow through these components are formed. The manifold 100 is formed by joining and integrating a plurality of housings, thereby forming a plurality of channels through which cooling water flows across at least two housings (in the present embodiment, a first housing 110 and a second housing 120 to be described later). Note that, as shown in FIG. 1, the cooling module 10 does not have a reserve tank therein. Because the cooling module 10 does not include a reserve tank, it is possible to configure the cooling module 10 to be compact and increase flexibility in disposition of the cooling module 10.

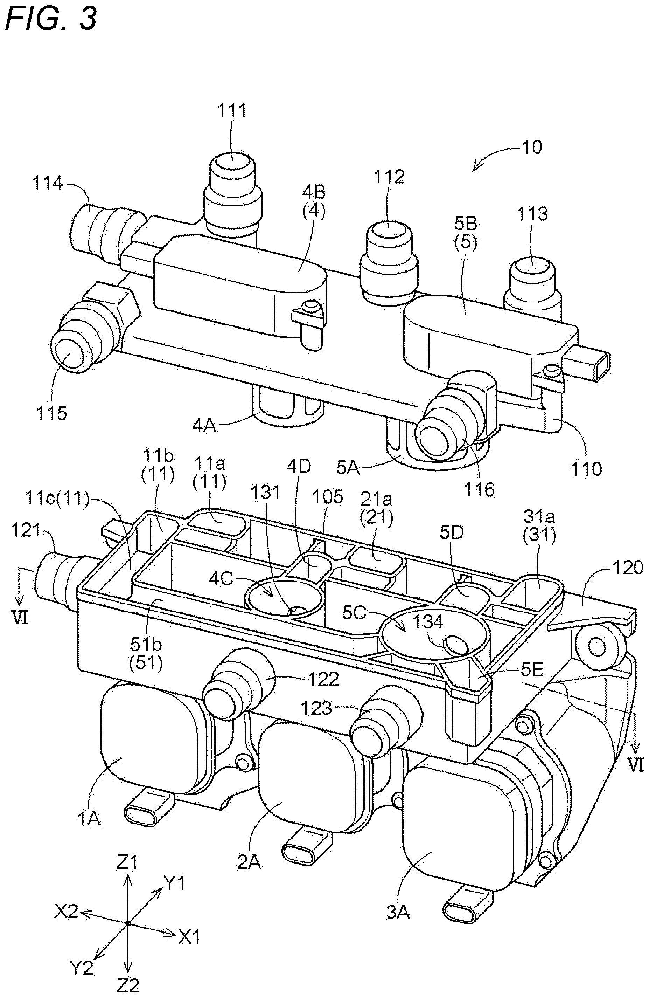

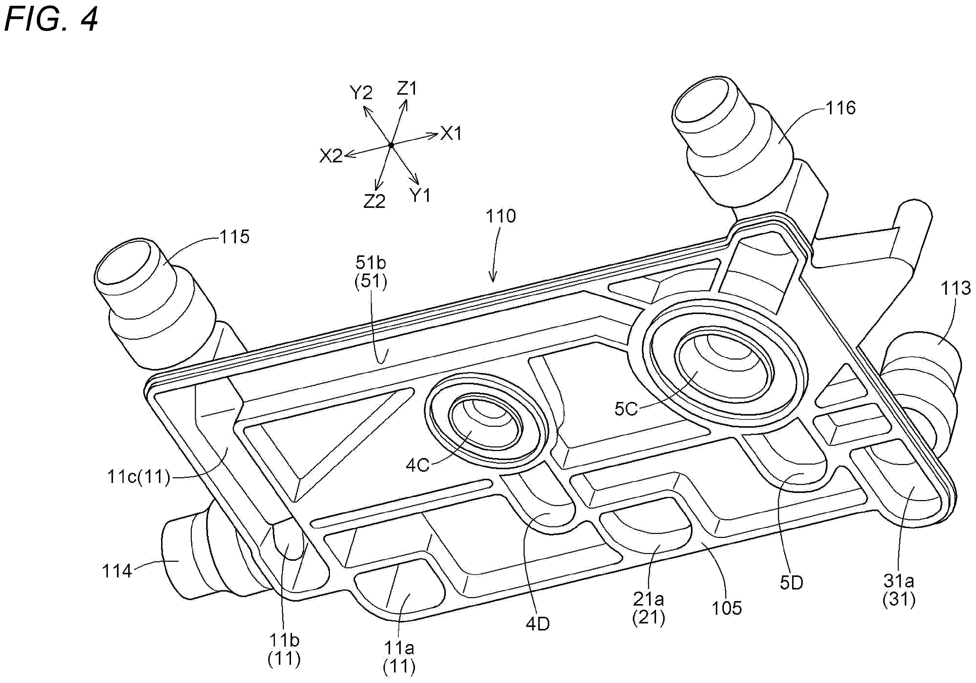

The manifold 100 is formed by joining and integrating the first housing 110 and the second housing 120, both made of resin, with a method such as vibration welding. The manifold 100 has a substantially rectangular cuboid shape as a whole, and as shown in FIGS. 3 and 4, a joining surface 105 between the first housing 110 and the second housing 120 has a planar shape. Hereinafter, a direction parallel to a longitudinal direction of the joining surface 105 is defined as an X direction, a direction parallel to a widthwise direction of the joining surface 105 is defined as a Y direction, and a direction perpendicular to the joining surface 105 is defined as a Z direction. That is, the joining surface 105 is parallel to an X-Y plane. Moreover, of the X direction, a direction from the first water pump 1A toward the third water pump 3A is defined as an X1 direction, and an opposite direction thereof is defined as an X2 direction. Of the Y direction, a direction from a second outflow port 115 toward a first inflow port 111 is defined as a Y1 direction, and an opposite direction thereof is defined as a Y2 direction (the second outflow port 115 and the first inflow port 111 will be described later.). Of the Z direction, a direction from the second housing 120 toward the first housing 110 is defined as a Z1 direction, and an opposite direction thereof is defined as a Z2 direction. The Z2 direction is a gravity direction. That is, the first housing 110 is disposed on an upper side of the second housing 120 in a vertical direction.

As shown in FIGS. 2 and 3, the first housing 110 is formed with the first inflow port 111, a second inflow port 112, a third inflow port 113, a first outflow port 114, the second outflow port 115, and a fifth outflow port 116. Furthermore, a third outflow port 121, a fourth outflow port 122, and a sixth outflow port 123 are formed in the second housing 120. All of the first inflow port 111, the second inflow port 112, the third inflow port 113, the first outflow port 114, the second outflow port 115, the third outflow port 121, the fourth outflow port 122, the fifth outflow port 116, and the sixth outflow port 123 have a cylindrical shape. The first inflow port 111, the second inflow port 112, and the third inflow port 113 are arranged side by side so that axes thereof are along the Z direction and on the same plane, and all of the ports have openings open in the Z1 direction. The first outflow port 114 and the third outflow port 121 are arranged side by side so that axes thereof are along the X direction and on the same plane, and both the ports have openings open in the X2 direction. The second outflow port 115 and the fifth outflow port 116 are arranged side by side so that axes thereof are along the Y direction and on the same plane, and both the ports have openings open in the Y2 direction. The fourth outflow port 122 and the sixth outflow port 123 are also arranged side by side such that their axes are along the Y direction and on the same plane, and both the ports have openings in the Y2 direction.

The first inflow port 111, the first outflow port 114, and the second outflow port 115 are included in the first circulation path 1, and all of the ports communicate with the first channel 11. The second inflow port 112 and the fourth outflow port 122 are included in the second circulation path 2, and both the ports communicate with the second channel 21. The third inflow port 113, the fifth outflow port 116, and the sixth outflow port 123 are included in the third circulation path 3, and all of the ports communicate with the third channel 31.

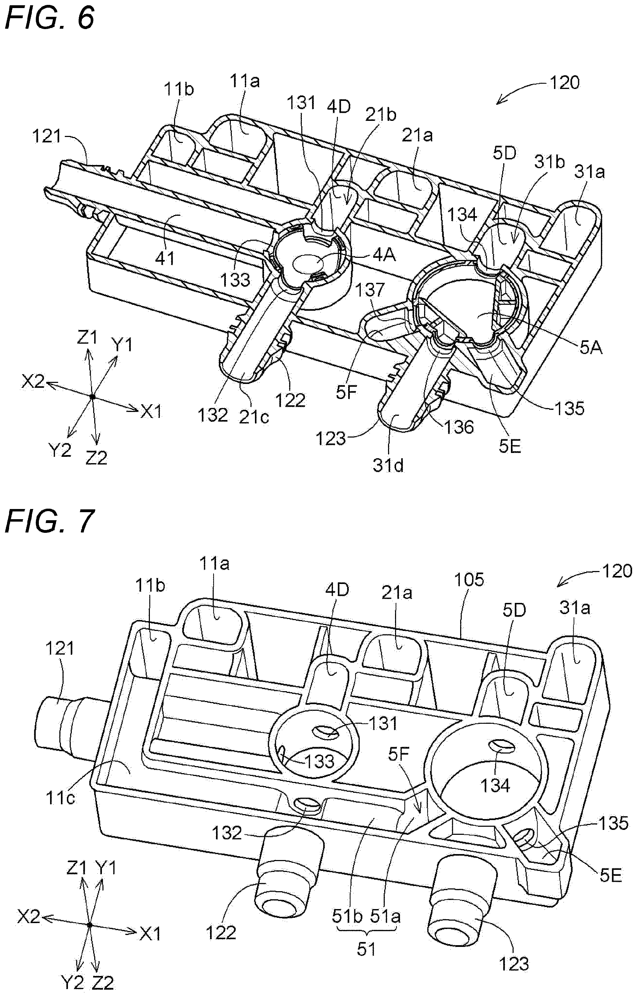

As shown in FIGS. 2 and 3, in the manifold 100, the first rotary valve 4 and the second rotary valve 5 are mounted between the first inflow port 111, the second inflow port 112, and the third inflow port 113, and the second outflow port 115 and the fifth outflow port 116 in the first housing 110 when the first housing 110 is viewed along the Z2 direction. In the first rotary valve 4 and the second rotary valve 5, a first actuator 4B that rotationally drives a first valve body 4A of the first rotary valve 4 and a second actuator 5B that rotationally drives a second valve body 5A of the second rotary valve 5 are exposed on an upper portion of the first housing 110. The first valve body 4A and the second valve body 5A are both positioned in the second housing 120 (refer to FIG. 6). Thus, a flow of the cooling water flowing through the plurality of channels can be controlled by switching between the channels formed in the second housing 120. Both the first rotary valve 4 and the second rotary valve 5 are an electromagnetic valve that can switch between the channels with an actuator, and rotate the first valve body 4A and the second valve body 5A about an axis along the Z direction to switch between the channels, thereby controlling the flow of the cooling water flowing through the plurality of channels. Note that the first valve body 4A is a three-way valve, and the second valve body 5A is a four-way valve. Details will be described later.

As shown in FIGS. 2 and 3, in the manifold 100, the first water pump 1A, the second water pump 2A, and the third water pump 3A are mounted on the second housing 120 in this order along the X1 direction. At this time, the first water pump 1A, the second water pump 2A, and the third water pump 3A are disposed such that respective rotation axes thereof are along the Y direction. In the second housing 120, there are formed a downward first sub-channel 11a (an example of the channel) communicating with the first inflow port 111 and extending in the Z direction, a downward second sub-channel 21a (an example of the channel) communicating with the second inflow port 112 and extending in the Z direction, and a downward third sub-channel 31a (an example of the channel) communicating with the third inflow port 113 and extending in the Z direction. The downward first sub-channel 11a, the downward second sub-channel 21a, and the downward third sub-channel 31a are formed across the first housing 110 and the second housing 120. The first water pump 1A pumps the cooling water flowing from the first inflow port 111 through the downward first sub-channel 11a. The second water pump 2A pumps the cooling water flowing from the second inflow port 112 through the downward second sub-channel 21a. The third water pump 3A pumps the cooling water flowing from the third inflow port 113 through the downward third sub-channel 31a. Note that the downward first sub-channel 11a is a part of the first channel 11, the downward second sub-channel 21a is a part of the second channel 21, and the downward third sub-channel 31a is a part of the third channel 31.

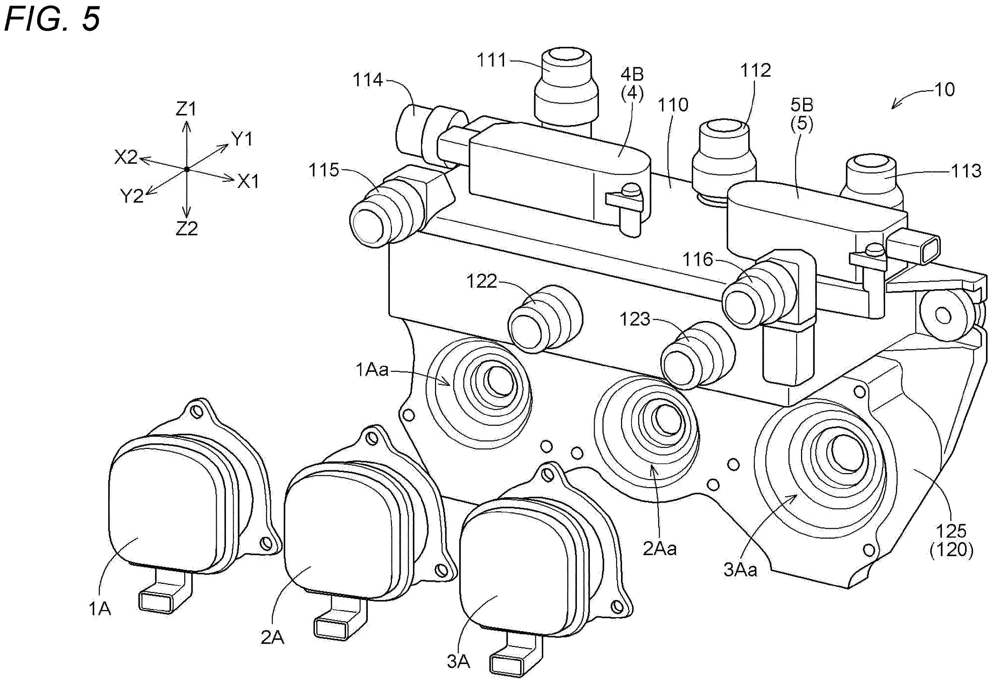

As shown in FIG. 5, the first water pump 1A, the second water pump 2A, and the third water pump 3A are mounted on a mounting portion 125 formed at an end portion (lower end in the vertical direction) of the second housing 120 in the Z2 direction. The mounting portion 125 is thicker than other portions of the second housing 120. Thus, it is possible to ensure strength of even a second housing 120 made of resin to be mounted with and hold the heavy first water pump 1A, the second water pump 2A, and the third water pump 3A.

In the mounting portion 125, there are formed a first vortex chamber 1Aa in which the cooling water flowing from the downward first sub-channel 11a into the first water pump 1A and discharged by rotation of an impeller (not shown) swirls, a second vortex chamber 2Aa in which the cooling water flowing from the downward second sub-channel 21a into the second water pump 2A and discharged by rotation of an impeller swirls, and a third vortex chamber 3Aa in which the cooling water flowing from the downward third sub-channel 31a into the third water pump 3A and discharged by rotation of an impeller swirls Thus, because the first vortex chamber 1Aa, the second vortex chamber 2Aa, and the third vortex chamber 3Aa are formed in the mounting portion 125, shrouds for regulating inflow and outflow directions of the cooling water are not required for the first water pump 1A, the second water pump 2A, and the third water pump 3A, and thus, downsizing, weight reduction, and cost reduction of the cooling module 10 is possible.

Thus, because the cooling module 10 incudes the plurality of channels formed by the manifold 100 extending across the first housing 110 and the second housing 120, the number of pipes can be reduced. Furthermore, because the manifold 100 is configured by joining the first housing 110 and the second housing 120, even if shapes and configuration of the channels in the manifold 100 are complicated due to consideration of positions and directions of the ports to which the pipes are connected, a shape of each of the first housing 110 and the second housing 120 can be simplified. Thus, because the pipes connected to the ports can be integrated to avoid redundant routing, lengths of the pipes connected to the ports can be shortened and simplified.

### [Flow of cooling water in cooling module]

Next, the flow of the cooling water in the cooling module 10 will be described with reference to FIGS. 3 and 6 to 8. First, the flow of the cooling water in the first circulation path 1 (refer to FIG. 9) will be described. As shown in FIG. 3, the cooling water cooled by the radiator 1B enters the second housing 120 of the cooling module 10 from the first inflow port 111, flows through the downward first sub-channel 11a in the Z2 direction, and flows into the first water pump 1A. The cooling water pumped by the first water pump 1A flows in the Z direction, through an upward first sub-channel 11b (an example of the channel) formed along the Z1 direction, and a lateral first sub-channel 11c (an example of the channel) branches from the upward first sub-channel 1 1b at the joining surface 105 between the first housing 110 and the second housing 120. As described above, because the first outflow port 114 is formed on the first housing 110, the cooling water flowing from the second housing 120 to the first housing 110 in the Z1 direction through the upward first sub-channel 11b changes a flowing direction in the X2 direction and flows out from the first outflow port 114. The cooling water flowing out of the cooling module 10 from the first outflow port 114 cools the DC-DC converter 1D and the charger 1E, and returns to the radiator 1B via the reserve tank 1F (refer to FIG. 1).

The lateral first sub-channel 11c is formed across the first housing 110 and the second housing 120, and is formed along the Y direction. That is, the lateral first sub-channel 11c is formed along the joining surface 105 between the first housing 110 and the second housing 120, and an upper half of the lateral first sub-channel 11c is formed in the first housing 110 and a lower half thereof is formed in the second housing 120. Then, the first housing 110 and the second housing 120 are joined to each other to form the lateral first sub-channel 11c. The cooling water flows through the lateral first sub-channel 11c in the Y2 direction and flows out of the cooling module 10 from the second outflow port 115 provided at a downstream end of the lateral first sub-channel 11c. The cooling water flowing out from the second outflow port 115 cools the inverter/motor 1C and returns to the radiator 1B via the reserve tank 1F (refer to FIG. 1). Note that the upward first sub-channel 11b and the lateral first sub-channel 11c constitute a part of the first channel 11.

Next, a flow of the cooling water in the second circulation path 2 (refer to FIG. 9) will be described. As shown in FIG. 3, the cooling water cooled by the heater core 2B enters the second housing 120 of the cooling module 10 from the second inflow port 112, flows through the downward second sub-channel 21a in the Z2 direction, and flows into the second water pump 2A. The cooling water pumped by the second water pump 2A flows in the Z1 direction through an upward second sub-channel 21b formed along the Z direction. A first spare chamber 4D, which is a space communicating with the upward second sub-channel 21b, is formed at a downstream end of the upward second sub-channel 21b. The first spare chamber 4D is disposed so as to be adjacent to a first valve chamber 4C of the first rotary valve 4 in the Y1 direction. The first spare chamber 4D communicates with the first valve chamber 4C through a first communication hole 131 opened along the Y direction. By providing the first spare chamber 4D, it is possible to change the flowing direction of the cooling water flowing through the upward second sub-channel 21b in the Z1 direction to the Y2 direction, and cause the cooling water to flow into the first valve chamber 4C from the first communication hole 131. Note that the first valve chamber 4C and the first spare chamber 4D are formed across the second housing 120 and the first housing 110.

As shown in FIG. 6, the first valve chamber 4C houses the first valve body 4A so that the first valve body 4A is rotatable about the axis along the Z direction. All the cooling water flowing through the upward second sub-channel 21b flows into the first valve chamber 4C through the first spare chamber 4D and the first communication hole 131. The first valve chamber 4C communicates with a lateral second sub-channel 21c through a second communication hole 132 opened along the Y direction, and communicates with a fourth channel 41 through a third communication hole 133 opened along the X direction. By rotating the first valve body 4A to switch between the channels, the cooling water flowing into the first valve chamber 4C flows to either the lateral second sub-channel 21c or a fourth channel 41. In the state shown in FIG. 6, the cooling water flows to the fourth channel 41. The lateral second sub-channel 21c extends along the Y direction, the fourth channel 41 extends along the X direction, and both the lateral second sub-channel 21c and the fourth channel 41 are formed in the second housing 120 (refer to FIG. 3). Note that the downward second sub-channel 21a, the upward second sub-channel 21b, the lateral second sub-channel 21c, the first valve chamber 4C, and the first spare chamber 4D constitute a part of the second channel 21, whereas the fourth channel 41 is not a part of the second channel 21 and does not constitute the second circulation path 2.

The cooling water flowing from the first valve chamber 4C into the lateral second sub-channel 21c through the second communication hole 132 flows in the Y2 direction, and flows out of the cooling module 10 from the fourth outflow port 122. The cooling water flowing out from the fourth outflow port 122 returns to the heater core 2B via the water-cooled condenser 2C and the electric heater 2D (refer to FIG. 1). The cooling water flowing into the fourth channel 41 from the first valve chamber 4C through the third communication hole 133 flows in the X2 direction and flows out of the cooling module 10 from the third outflow port 121. The cooling water flowing out from the second outflow port 115 flows into the radiator 1B via the reserve tank 1F (refer to FIG. 1). The first rotary valve 4 causes the first actuator 4B to rotate the first valve body 4A about the axis along the Z direction, thereby causing the cooling water flowing through the upward second sub-channel 21b and flowing into the first valve chamber 4C to flow by switching between the lateral second sub-channel 21c and the fourth channel 41.

Next, a flow of the cooling water in the third circulation path 3 (refer to FIG. 9) will be described. As shown in FIG. 3, the cooling water cooled the battery 3B enters the second housing 120 of the cooling module 10 from the third inflow port 113, flows through the downward third sub-channel 31a in the Z2 direction, and flows into the third water pump 3A. The cooling water pumped by the third water pump 3A flows in the Z1 direction through an upward third sub-channel 31b formed along the Z direction. The second spare chamber 5D, which is a space communicating with the upward third sub-channel 31b, is formed at a downstream end of the upward third sub-channel 31b. The second spare chamber 5D is disposed so as to be adjacent to the second valve chamber 5C of the second rotary valve 5 in the Y1 direction. The second spare chamber 5D communicates with the second valve chamber 5C through a fourth communication hole 134 opened along the Y direction. By providing the second spare chamber 5D, it is possible to change the flowing direction of the cooling water flowing through the upward third sub-channel 31b in the Z1 direction to the Y2 direction, and cause the cooling water to flow into the second valve chamber 5C from the fourth communication hole 134. Note that the second valve chamber 5C and the second spare chamber 5D are formed across the second housing 120 and the first housing 110.

As shown in FIG. 6, the second valve chamber 5C houses the second valve body 5A so that the second valve body 5A is rotatable about the axis along the Z direction. All the cooling water flowing through the upward third sub-channel 31b flows into the second valve chamber 5C through the second spare chamber 5D and the fourth communication hole 134. The second valve chamber 5C communicates with a lateral third sub-channel 31d through a sixth communication hole 136 opened along the Y direction. Furthermore, the second valve chamber 5C communicates with a third spare chamber 5E and a fourth spare chamber 5F through a fifth communication hole 135 and a seventh communication hole 137 respectively, the holes being opened adjacent to each other on both sides in a circumferential direction across the sixth communication hole 136. The third spare chamber 5E and the fourth spare chamber 5F are formed across the second housing 120 and the first housing 110. By rotating the second valve body 5A to switch between the channels, the cooling water flowing into the second valve chamber 5C flows to any one of the lateral third sub-channel 31d, the third spare chamber 5E, and the fourth spare chamber 5F. In the state shown in FIG. 6, the cooling water flows to the third spare chamber 5E.

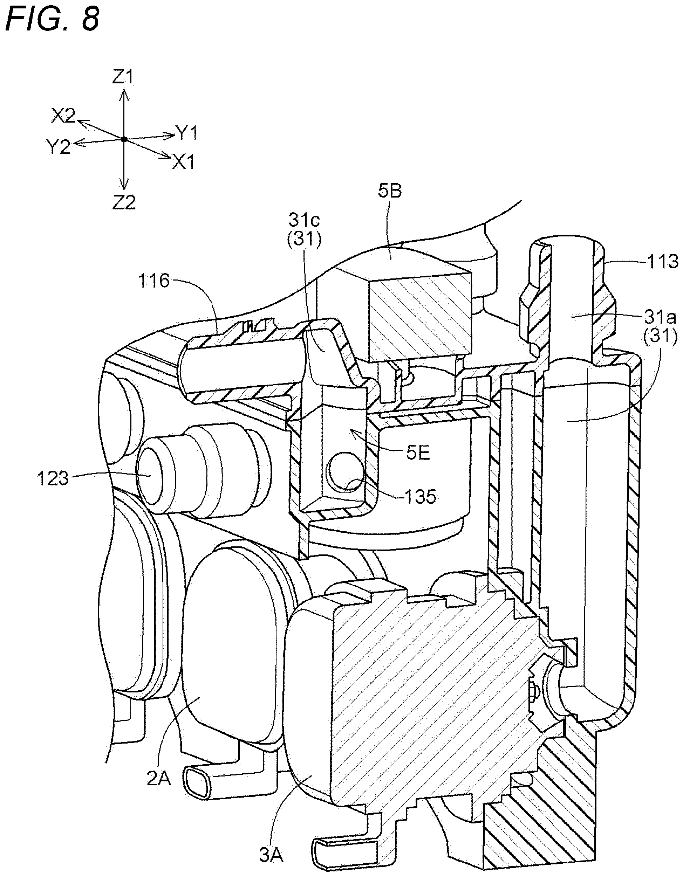

As shown in FIG. 8, the third spare chamber 5E communicates with the fifth outflow port 116 through an L-shaped third sub-channel 31c extending along the Z direction. By providing the third spare chamber 5E, it is possible to change the flowing direction of the cooling water, which flows in a direction perpendicular to the Z direction into the third spare chamber 5E from the second valve chamber 5C through the fifth communication hole 135, to the Z1 direction to cause the cooling water to flow through the L-shaped third sub-channel 31c and flow out of the cooling module 10 from the fifth outflow port 116. The cooling water flowing out from the fifth outflow port 116 returns to the battery 3B via the electric heater 3D (refer to FIG. 1). The cooling water flowing from the second valve chamber 5C into the lateral third sub-channel 31d through the sixth communication hole 136 flows in the Y2 direction, and flows out of the cooling module 10 from the sixth outflow port 123. The cooling water flowing out from the sixth outflow port 123 returns to the battery 3B via the chiller 3C (refer to FIG. 1). Note that the downward third sub-channel 31a, the upward third sub-channel 31b, the L-shaped third sub-channel 31c, the lateral third sub-channel 31d, the second valve chamber 5C, the second spare chamber 5D, and the third spare chamber 5E constitute a part of the third channel 31.

As shown in FIGS. 3 and 7, the fourth spare chamber 5F communicates with the communication channel 51 extending in the Z direction from the fourth spare chamber 5F and then bent, extending in the X direction. In the communication channel 51, a first portion 51a extending in the Z direction is formed in the second housing 120, and a second portion 51b extending in the X direction is formed across the first housing 110 and the second housing 120. That is, the second portion 51b of the communication channel 51 is formed along the joining surface 105 between the first housing 110 and the second housing 120, and an upper half of the second portion 51b is formed in the first housing 110 and a lower half of the second portion 51b is formed in the second housing 120. The communication channel 51 is not a part of the third channel 31 and does not constitute the third circulation path 3.

As described above, the communication channel 51 allows first channel 11, second channel 21, and third channel 31 to communicate with each other in the cooling module 10. By providing the communication channel 51 in this manner, the three circulation paths through which the cooling water circulates can be integrated, and thus the number of pipes connected to the ports can be reduced, and lengths of the pipes can be shortened and simplified.

The second portion 51b of the communication channel 51 is connected to the lateral first sub-channel 11c at an end portion opposite to the fourth spare chamber 5F. Furthermore, the second portion 51b intersects with the lateral second sub-channel 21c when viewed along the Z direction. The second portion 51b is recessed in the Z2 direction to be connected to the lateral second sub-channel 21c at the intersection.

The second rotary valve 5 causes the second actuator 5B to rotate the second valve body 5A about the axis along the Z direction to cause the cooling water to flow from the upward third sub-channel 31b into the second valve chamber 5C by switching among three ways that are (1) causing the cooling water to flow from the fifth communication hole 135 through the third spare chamber 5E and the L-shaped third sub-channel 31c, and flow out from the fifth outflow port 116, (2) causing the cooling water to flow from the seventh communication hole 137 through the fourth spare chamber 5F and the communication channel 51, and flow out from the second outflow port 115, and (3) causing the cooling water to flow from the seventh communication hole 137 through the fourth spare chamber 5F and the communication channel 51 and the lateral second sub-channel 21c, and flow out from the second outflow port 115 and the fourth outflow port 122, and to flow from the sixth communication hole 136 through the lateral third sub-channel 31d and flow out from the sixth outflow port 123.

### [Usage of cooling system]

Next, a usage of the cooling system A during traveling of the electric vehicle will be described. First, a usage of the cooling system A when the electric vehicle is traveling with a temperature of the cooling system A being extremely low (for example, 0 °C or lower) (hereinafter, referred to as a first aspect) will be described with reference to FIG. 9. This corresponds to, for example, a state immediately after the electric vehicle is caused to travel without being warmed up due to an extremely low ambient temperature. At this time, while the inverter/motor 1C, the DC-DC converter 1D, and the charger 1E need to supply cooled cooling water, the heater core 2B and the battery 3B need to supply heated cooling water. Therefore, in the first aspect, the first circulation path 1, the second circulation path 2, and the third circulation path 3 operate independently. Hereinafter, in FIGS. 9 to 12, the first circulation path 1, the second circulation path 2, and the third circulation path 3 are denoted by thick solid lines.

In the first circulation path 1, the first water pump 1A operates, and the cooling water flowing into the first inflow port 111 from the radiator 1B is pumped by the first water pump 1A, flows through the first channel 11, flows out from the first outflow port 114 and the second outflow port 115, and returns to the radiator 1B via the reserve tank 1F. Because the cooling water is cooled by the radiator 1B, the inverter/motor 1C, the DC-DC converter 1D, and the charger 1E are cooled.

In the second circulation path 2, the second water pump 2A is operated, and the first rotary valve 4 is switched so as to connect the first valve chamber 4C and the lateral second sub-channel 21c (refer to FIG. 6), and the cooling water flowing from the heater core 2B into the second inflow port 112 is pumped by the second water pump 2A, flows through the second channel 21, and flows out from the fourth outflow port 122. The cooling water flowing out from the cooling module 10 is heated by the electric heater 2D and returns to the heater core 2B. At this time, the water-cooled condenser 2C does not operate.

In the third circulation path 3, the third water pump 3A is operated, and the second rotary valve 5 is switched so as to connect the second valve chamber 5C and the third spare chamber 5E (refer to FIG. 6), and the cooling water flowing from the battery 3B into the third inflow port 113 is pumped by the third water pump 3A, flows through the third channel 31, and flows out from the fifth outflow port 116. The cooling water flowing out from the cooling module 10 is heated by the electric heater 3D and returns to the battery 3B. Thus, the battery 3B is warmed by the cooling water.

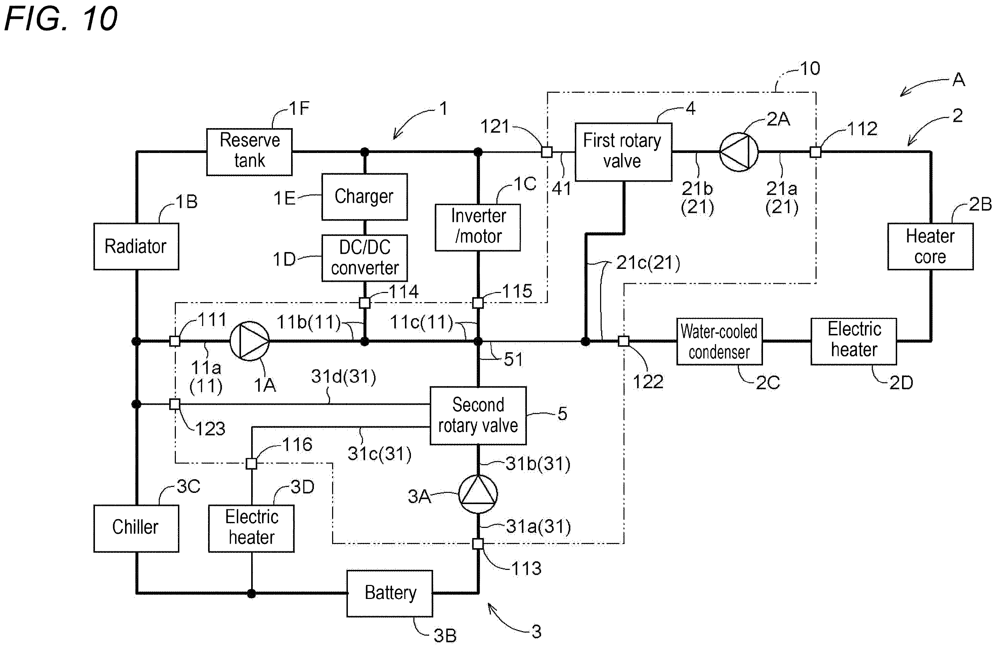

Next, a usage of the cooling system A when the electric vehicle is traveling with a temperature of the cooling system A being not extremely low, but still low (for example, 0°C to 10°C) (hereinafter, referred to as a second aspect) will be described with reference to FIG. 10. This corresponds to, for example, a state where the ambient temperature is extremely low and the electric vehicle travels and slightly warmed up. At this time also, while the inverter/motor 1C, the DC-DC converter 1D, and the charger 1E need to supply cooled cooling water, the heater core 2B and the battery 3B need to supply heated cooling water. In the second aspect, the first circulation path 1 and the second circulation path 2 circulate the cooling water in the same manner as in the first aspect, and thus detailed description thereof will be omitted.

In the third circulation path 3, the third water pump 3A is operated, and the second rotary valve 5 is switched so as to connect the second valve chamber 5C and the fourth spare chamber 5F (the second valve body 5A is rotated clockwise by 90 degrees from the state shown in FIG. 6), and the cooling water flowing from the battery 3B into the third inflow port 113 is pumped by the third water pump 3A, flows into the second valve chamber 5C, flows from the fourth spare chamber 5F through the communication channel 51, and then flows out from the second outflow port 115. At this time, the cooling water flowing through the communication channel 51 does not flow into the lateral second sub-channel 21c. The cooling water flowing out from the cooling module 10 flows through the inverter/motor 1C, the reserve tank 1F, and the radiator 1B, and returns to the battery 3B through the chiller 3C. However, the chiller 3C is not operated, and thus the cooling water is not cooled by the chiller 3C. In the second aspect, the first circulation path 1 and the third circulation path 3 integrally circulate the cooling water, and the battery 3B is warmed by utilizing the cooling water heated by the inverter/motor 1C, the DC-DC converter 1D, and the charger 1E. Note that the channel connecting the radiator 1B and the chiller 3C is branched in the middle, and some of the cooling water flows to the first inflow port 111. Thus, the first circulation path 1 of the first aspect is configured.

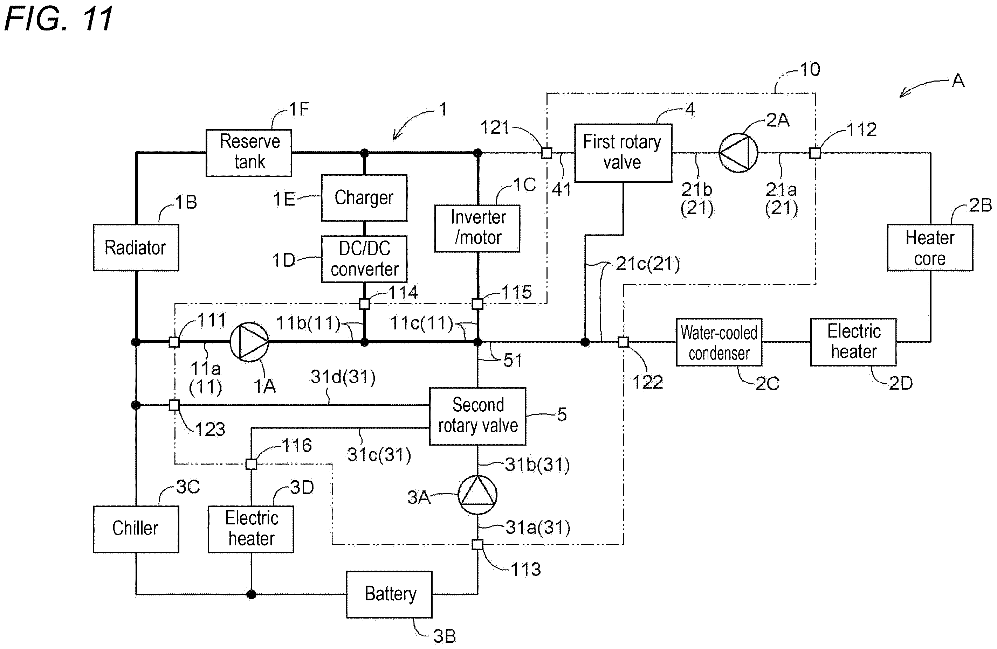

Next, a usage of the cooling system A when the electric vehicle is traveling with a temperature of the cooling system A being a normal temperature (for example, 10°C to 30°C) that is higher than a low temperature (hereinafter, referred to as a third aspect) will be described with reference to FIG. 11. This corresponds to, for example, a state where warm-up has been completed by the electric vehicle traveling (normal traveling state). In the third aspect, the first circulation path 1 circulates the cooling water in the same manner as in the first aspect, and thus detailed description thereof will be omitted. Meanwhile, because the operations of the second water pump 2A and the third water pump 3A are stopped, the cooling water does not flow (return) through the second circulation path 2 and the third circulation path 3.

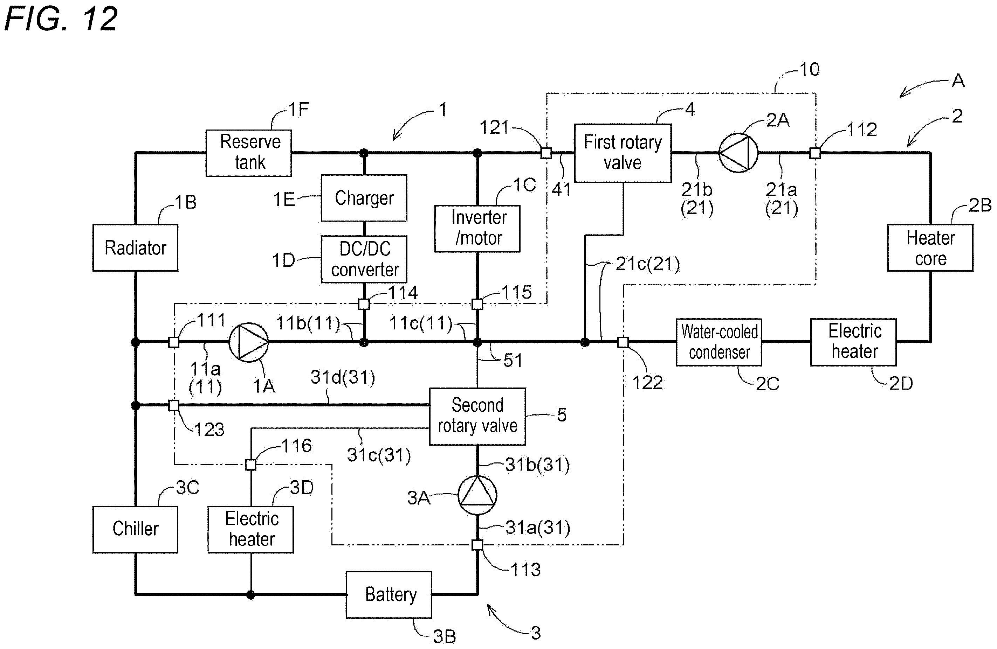

Next, a usage of the cooling system A when the electric vehicle is traveling with a temperature of the cooling system A being higher than the normal temperature (for example, 30°C or higher) (hereinafter, referred to as a fourth aspect) will be described with reference to FIG. 12. This corresponds to, for example, a state where the electric vehicle travels for a long time in an environment in which the inverter/motor 1C requires a high torque. At this time, because the inverter/motor 1C, the DC-DC converter 1D, the charger 1E, and the battery 3B are in a high temperature state, it is necessary to supply the cooling water to cool them. In the fourth aspect, the first circulation path 1 circulates the cooling water in the same manner as in the first aspect, and thus detailed description thereof will be omitted.

In the second circulation path 2, the second water pump 2A is operated, and the first rotary valve 4 is switched so as to connect the first valve chamber 4C and the fourth channel 41 (the first valve body 4A is rotated counterclockwise by 90 degrees from the state shown in FIG. 6), and the cooling water flowing from the heater core 2B into the second inflow port 112 is pumped by the second water pump 2A, flows through the upward second sub-channel 21b, the first valve chamber 4C, and the fourth channel 41, and then flows out from the third outflow port 121. As described above, the cooling water flowing out of the cooling module 10 from the third outflow port 121 flows into the radiator 1B via the reserve tank 1F. The cooling water flowing into the radiator 1B and cooled flows into the first inflow port 111 that constitutes the first circulation path 1. Then, after being pumped by the first water pump 1A, the cooling water flows through the upward first sub-channel 11b, the lateral first sub-channel 11c, the communication channel 51, and the lateral second sub-channel 21c, and flows out of the cooling module 10 from the fourth outflow port 122. Thereafter, the cooling water is cooled by the water-cooled condenser 2C and returned to the heater core 2B. At this time, the electric heater 2D is not operated. In the fourth aspect, the second circulation path 2 is integrated with the first circulation path 1 to circulate and cool the cooling water. At this time, some of the cooling water flowing out from the radiator 1B flows into the chiller 3C.

In the third circulation path 3, the third water pump 3A is operated, and the second rotary valve 5 is switched so as to connect the second valve chamber 5C and the lateral third sub-channel 31d (the second valve body 5A is rotated clockwise by 45 degrees from the state shown in FIG. 6), and the cooling water flowing from the battery 3B into the third inflow port 113 is pumped by the third water pump 3A, flows into the second valve chamber 5C, then flows into the lateral third sub-channel 31d.

The cooling water flowing into the lateral third sub-channel 31d flows out from the sixth outflow port 123. The cooling water flowing out from the cooling module 10 returns to the battery 3B through the chiller 3C. At this time, the cooling water is cooled by the chiller 3C.

Thus, in the cooling module 10, all the inflow ports are formed along the Z direction, and all the outflow ports are formed along the X direction or the Y direction. In particular, the first inflow port 111, the second inflow port 112, and the third inflow port 113 are arranged side by side so that axes thereof are along the Z direction and on the same plane. Furthermore, the first outflow port 114 and the third outflow port 121 are arranged side by side so that axes thereof are along the X direction and on the same plane. Moreover, the second outflow port 115 and the fifth outflow port 116 are arranged side by side so that axes thereof are along the Y direction and on the same plane. The fourth outflow port 122 and the sixth outflow port 123 are also arranged side by side so that axes thereof are along the Y direction and on the same plane. By aligning the orientations and dispositions of the plurality of inflow ports and plurality of outflow ports in this manner, the pipes connected to the inflow port and the outflow port can be integrated to avoid redundant routing, and thus lengths of the pipes in a circuit in the cooling system A can be shortened and simplified.

### [Other embodiments]

(1) In the present embodiment, the manifold 100, the lateral first sub-channel 11c, and the communication channel 51 are formed by joining the two members, the first housing 110 and the second housing 120, but the present invention is not limited thereto. At least one of the manifold 100, the lateral first sub-channel 11c, and the communication channel 51 may be formed by joining three or more members.
(2) In the present embodiment, the first water pump 1A, the second water pump 2A, the third water pump 3A, the first rotary valve 4, and the second rotary valve 5 are used as auxiliary units mounted on the cooling module 10, but the present invention is not limited thereto, and other auxiliary units may be mounted. Other examples of the auxiliary unit include pumps such as a battery pump and a powertrain pump, the chiller 3C, the electric heaters 2D and 3D, a filter, an aerator, a valve, a connector, a fan, the radiator 1B, and the like.
(3) In the present embodiment, the manifold 100 is provided with channels such as the first channel 11, the second channel 21, the third channel 31, the fourth channel 41, and the communication channel 51, but the present invention is not limited thereto. The number and disposition of the channels including communication paths, positions and opening direction of the inflow/outflow ports, and the number of the inflow/outflow ports in the manifold 100 can be appropriately changed depending on a type and the number of the auxiliary units, and a configuration of the cooling circuit.

### INDUSTRIAL APPLICABILITY

The present invention can be utilized in a cooling module.

### REFERENCE SIGNS LIST

1: First circulation path, 1A: First water pump (second auxiliary unit), 1Aa: First vortex chamber, 1B: Radiator, 2: Second circulation path, 2A: Second water pump (second auxiliary unit), 2Aa: Second vortex chamber, 2B: Heater core, 3: Third circulation path, 3A: Third water pump (second auxiliary unit), 3Aa: Third vortex chamber, 3B: Battery, 4: First rotary valve (first auxiliary unit), 5: Second rotary valve (first auxiliary unit), 10: Cooling module, 11: First channel, 21: Second channel, 31: Third channel, 11a: Downward first sub-channel (channel), 11b: Upward first sub-channel (channel), 11c: First sub-channel (channel), 21a: Downward second sub-channel (channel), 31a: Downward third sub-channel (channel), 51: Communication channel (channel), 100: Manifold, 105: Joining surface, 110: First housing (housing), 111: First inflow port, 112: Second inflow port, 113: Third inflow port, 120: Second housing (housing), and 125: Mounting portion

## Claims

1. A cooling module not comprising a reserve tank inside, but comprising a manifold made of resin and including a plurality of housings joined to each other, wherein
the manifold includes a plurality of channels formed across at least two of a plurality of the housings.

2. The cooling module according to claim 1, further comprising a first auxiliary unit and a second auxiliary unit that control flow of fluid flowing through the channels, wherein
a plurality of the housings include a first housing and a second housing joined to the first housing, and
the first auxiliary unit is mounted on the first housing, and the second auxiliary unit is mounted on the second housing.

3. The cooling module according to claim 2, wherein
the first housing is disposed joined to an upper side of the second housing in a vertical direction,
the first housing includes a plurality of inflow ports communicating with a plurality of the respective channels, and
a plurality of the inflow ports are arranged side by side so that axes of the respective inflow ports are along the vertical direction and on the same plane.

4. The cooling module according to claim 3, wherein
the first auxiliary unit is a rotary valve, and
a valve body of the rotary valve is positioned in the second housing.

5. The cooling module according to any one of claims 2 to 4, wherein
the second housing includes a mounting portion on which the second auxiliary unit is mounted, and
the mounting portion is thicker than other portions.

6. The cooling module according to any one of claims 2 to 5, wherein
the second auxiliary unit is a water pump that pumps the fluid, and
the water pump and the second housing constitute a vortex chamber through which pumped the fluid flows.

7. The cooling module according to any one of claims 1 to 6, wherein
a plurality of the channels include a first channel that constitutes a part of a first circulation path that circulates through a radiator, a second channel that constitutes a part of a second circulation path that circulates through a heater core, a third channel that constitutes a part of a third circulation path that circulates through a battery, and a communication channel that allows the first channel, the second channel, and the third channel to communicate with one another.

8. The cooling module according to claim 7, wherein the communication channel is formed along a joining surface of each of a plurality of the housings.
